(19) Europäisches Patentamt
European Patent Office
Office européen des brevets

(11) **EP 4 333 001 A1**

(12) **EUROPEAN PATENT APPLICATION**
published in accordance with Art. 153(4) EPC

(43) Date of publication:
**06.03.2024 Bulletin 2024/10**

(21) Application number: **22795700.8**

(22) Date of filing: **22.04.2022**

(51) International Patent Classification (IPC):
**H01G 4/06** (2006.01)        **H01G 9/00** (2006.01)
**H01G 9/07** (2006.01)

(52) Cooperative Patent Classification (CPC):
**H01G 4/06; H01G 9/00; H01G 9/07**

(86) International application number:
**PCT/JP2022/018645**

(87) International publication number:
**WO 2022/230787 (03.11.2022 Gazette 2022/44)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **26.04.2021   JP 2021074114
28.04.2021   JP 2021076881**

(71) Applicant: **Panasonic Intellectual Property
Management Co., Ltd.
Kadoma-shi, Osaka 571-0057 (JP)**

(72) Inventors:
• **KANOU, Manabu**
**Kadoma-shi, Osaka 571-0057 (JP)**
• **KATO, Yuya**
**Kadoma-shi, Osaka 571-0057 (JP)**
• **KOSHIKAWA, Hiroyuki**
**Kadoma-shi, Osaka 571-0057 (JP)**
• **SUZUKA, Michio**
**Kadoma-shi, Osaka 571-0057 (JP)**

(74) Representative: **Eisenführ Speiser
Patentanwälte Rechtsanwälte PartGmbB
Gollierstraße 4
80339 München (DE)**

(54) **CAPACITOR, ELECTRIC CIRCUIT, CIRCUIT BOARD, AND APPARATUS**

(57)    A capacitor 1a of the present disclosure includes a first electrode 11, a second electrode 12, and a dielectric 20. The second electrode 12 is disposed to face a principal surface of the first electrode 11. The dielectric 20 is disposed between the first electrode 11 and the second electrode 12. The dielectric 20 is in contact with the first electrode 11 and the second electrode 12. A surface of the second electrode 12 extends, for example, parallel to a surface of the first electrode 11, the surfaces each being in contact with the dielectric 20. An electrical conductivity $\sigma_x$ of the dielectric 20 in a particular direction perpendicular to the principal surface and an electrical conductivity $\sigma_y$ of the dielectric 20 in a direction perpendicular to the particular direction satisfy a relation $\sigma_x/\sigma_y \leq 0.01$.

FIG.1

EP 4 333 001 A1

**Description**

TECHNICAL FIELD

The present invention relates to a capacitor, an electrical circuit, a circuit board, and an apparatus.

BACKGROUND ART

Intercalation of diamines into $SnS_2$ have been performed.

For example, Non Patent Literature 1 shows the result of AC impedance measurement of a sample obtained by intercalation of an alkyldiamine such as ethylenediamine or propylenediamine into single-crystal. In this measurement, the sample is produced by pressurization at a pressure of 6 tons/cm$^{-2}$. According to the measurement result, the bulk electrical conductivity of the sample at room temperature is approximately $7 \times 10^{-9}$ S/cm.

Non Patent Literature 2 describes a method for intercalating ethylenediamine, p-phenylenediamine, or 1 ,5-naphthalenediamine into $SnS_2$. Optical properties of a sample produced by this method are measured in Non Patent Literature 2. However, Non Patent Literature 2 fails to describe electrical-conduction-related properties, such as impedance properties, of the sample.

CITATION LIST

Non Patent Literature

Non Patent Literature 1: Morales, Julian, et al. "Synthesis and characterization of diamine intercalation compounds of SnS2 single crystals." Journal of Solid State Chemistry 150.2 (2000): 391-398
Non Patent Literature 2: Toh, M. L., et al. "Intercalation of organic molecules into SnS2 single crystals." Journal of Solid State Chemistry 198 (2013): 224-230

SUMMARY OF INVENTION

Technical Problem

Non Patent Literatures 1 and 2 explore only materials obtained by intercalation of diamines into $SnS_2$, and fail to specifically explore capacitors. The present disclosure therefore provides a new capacitor.

Solution to Problem

A capacitor of the present disclosure includes:

a first electrode;
a second electrode disposed to face a principal surface of the first electrode; and
a dielectric disposed between the first electrode and the second electrode, the dielectric being in contact with the first electrode and the second electrode, wherein
an electrical conductivity $\sigma_x$ of the dielectric in a particular direction perpendicular to the principal surface and an electrical conductivity $\sigma_y$ of the dielectric in a direction perpendicular to the particular direction satisfy a relation $\sigma_x/\sigma_y \leq 0.01$.

Advantageous Effects of Invention

According to the present disclosure, a new capacitor can be provided.

BRIEF DESCRIPTION OF DRAWINGS

FIG. 1 schematically shows a capacitor according to the embodiment of the present disclosure.
FIG. 2 shows an example of a layered structure of a dielectric according to the embodiment of the present disclosure.

FIG. 3 is a cross-sectional view schematically showing a dielectric-including member according to an example of the embodiment of the present disclosure.

FIG. 4 shows an example of a crystal structure of a layered double hydroxide.

FIG. 5 schematically shows an exemplary mechanism to produce a dielectric-including member.

FIG. 6 schematically shows another exemplary mechanism to produce a dielectric-including member.

FIG. 7 schematically shows another example of the capacitor according to the embodiment of the present disclosure.

FIG. 8A schematically shows an electrical circuit according to the embodiment of the present disclosure.

FIG. 8B schematically shows a circuit board according to the embodiment of the present disclosure.

FIG. 8C schematically shows an apparatus according to the embodiment of the present disclosure.

FIG. 9 shows results of measuring and calculating X-ray diffraction (XRD) patterns of single-crystal $SnS_2$ and a sample according to Example 1.

FIG. 10 shows a method for producing a specimen for AC impedance measurement of a specimen according to Example 1.

FIG. 11A shows a Nyquist plot obtained from an AC impedance measurement result for the specimen according to Example 1.

FIG. 11B shows an equivalent circuit used for fitting in FIG. 11A.

FIG. 12A is a graph showing a relation between an electrical conductivity of the specimen according to Example 1 in a thickness direction thereof and a frequency of AC voltage.

FIG. 12B is a graph showing a relation between an electrical conductivity of the specimen according to Example 1 in an in-plane direction thereof and a frequency of AC voltage.

FIG. 13 is a graph showing a relation between a dielectric constant of the specimen according to Example 1 and a frequency of AC voltage.

FIG. 14A shows a Nyquist plot obtained from an AC impedance measurement result for a specimen according to Comparative Example 1.

FIG. 14B shows an equivalent circuit used for fitting in FIG. 14A.

FIG. 15A is a Bode plot showing a relation between an absolute value of a resistance of the specimen according to Comparative Example 1 and a frequency of AC voltage.

FIG. 15B is a Bode plot showing a relation between a phase of a resistance of the specimen according to Comparative Example 1 and a frequency of AC voltage.

FIG. 16A shows a Nyquist plot obtained from an AC impedance measurement result for a specimen according to Comparative Example 2.

FIG. 16B shows an equivalent circuit used for fitting in FIG. 16A.

FIG. 17A is a Bode plot showing a relation between an absolute value of a resistance of the specimen according to Comparative Example 2 and a frequency of AC voltage.

FIG. 17B is a Bode plot showing a relation between a phase of a resistance of the specimen according to Comparative Example 2 and a frequency of AC voltage.

FIG. 18 is a graph showing a relation between an electrical conductivity of the specimen according to Comparative Example 2 in a thickness direction thereof and a frequency of AC voltage.

FIG. 19 is a photograph of a dielectric-including member according to Example 2.

FIG. 20 is a photograph of a dielectric-including member according to Example 3.

FIG. 21 is a graph showing relations between electrical conductivities of the specimen according to Example 2 in a thickness direction thereof and an in-plane direction thereof and a frequency of AC voltage.

FIG. 22A schematically shows occurrence of current leakage attributable to anisotropy of electrical conduction in a bulk for a material having a large electrical conductivity anisotropy and a low degree of orientation.

FIG. 22B schematically shows occurrence of current leakage attributable to electrical conduction on a grain boundary for a material having a large electrical conductivity anisotropy and a low degree of orientation.

FIG. 23 shows an equivalent circuit used for AC impedance measurement of a sample described in Non Patent Literature 1.

## DESCRIPTION OF EMBODIMENTS

(Findings on which the present disclosure is based)

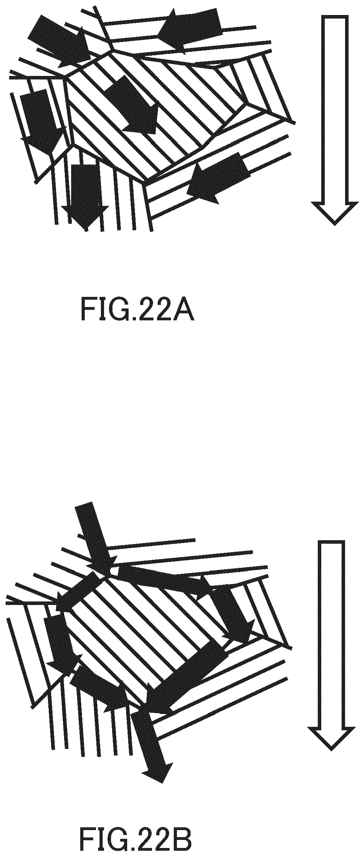

A material having a large electrical conductivity anisotropy can be used as a dielectric of a capacitor. In that case, occurrence of current leakage may pose a problem for the dielectric of the capacitor. FIG. 22A schematically shows occurrence of current leakage attributable to anisotropy of electrical conduction in a bulk for a material having a large electrical conductivity anisotropy and a low degree of orientation. In FIG. 22A, a white arrow represents a direction of an applied voltage, while a black arrow represents an electric current in a bulk. FIG. 22B schematically shows occurrence of current leakage attributable to anisotropy of electrical conduction on a grain boundary for a material having a large electrical conductivity anisotropy and a low degree of orientation. In FIG. 22B, a white arrow represents a direction of an applied voltage, while a black arrow represents an electric current on a grain boundary.

As shown in FIG. 22A, when a voltage is applied to a material having a large electrical conductivity anisotropy and a low degree of orientation, an electric current flows in a bulk in a direction where the electrical conductivity is higher and current leakage can occur. In addition, when a voltage is applied to a material having a large electrical conductivity anisotropy, a low degree of orientation, and a low electrical resistance on a grain boundary, current leakage can occur due to electrical conduction on the grain boundary. Therefore, current leakage tends to occur in a capacitor including a material having a large electrical conductivity anisotropy and a low degree of orientation, and it may be difficult for the capacitor to achieve desired properties.

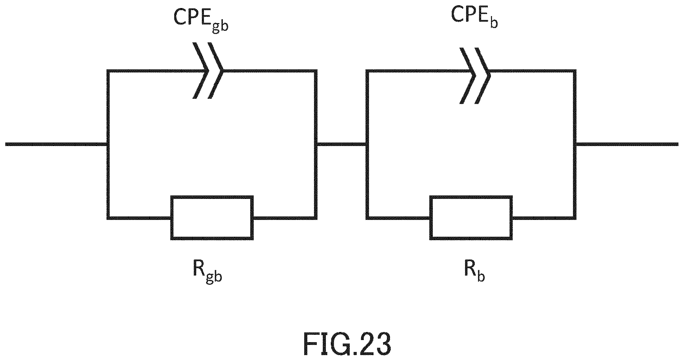

In Non Patent Literature 1, a pressure of 6 tons/cm$^{-2}$, or equivalently, a pressure of 588 MPa, is applied for measurement of electrical conductivity. The application of such a high pressure is thought to cause distortion of a crystal grain and shear-stress-induced polycrystallization in a sample. FIG. 23 shows an equivalent circuit used for AC impedance measurement of a sample described in Non Patent Literature 1. In FIG. 23, $CPE_{gb}$ is a constant-phase element (CPE) at a grain boundary, and $CPE_b$ is a CPE in a bulk. Additionally, $R_{gb}$ is a grain boundary resistance, and $R_b$ is a bulk resistance. As can be understood from FIG. 23, the equivalent circuit for the sample described in Non Patent Literature 1 is a circuit in which a capacitor and a resistance attributable to a grain boundary and a capacitor and a resistance attributable to a bulk are combined in series. In the sample described in Non Patent Literature 1, the application of the above high pressure is thought to cause polycrystallization to decrease the degree of orientation of crystals. For example, a Nyquist plot for the sample described in Non Patent Literature 1 shows an arc-shaped locus; it is understood that current leakage will occur in a capacitor configured using this sample.

In view of these circumstances, the present inventors made intensive studies to create a capacitor including, as a dielectric, a material having a large electrical conductivity anisotropy, the capacitor being capable of reducing current leakage. Through a lot of trial and error, the present inventors have finally devised a capacitor of the present disclosure.

(Summary of one aspect according to the present disclosure)

A capacitor according to a first aspect of the present disclosure includes:

a first electrode;
a second electrode disposed to face a principal surface of the first electrode; and
a dielectric disposed between the first electrode and the second electrode, the dielectric being in contact with the first electrode and the second electrode, wherein
an electrical conductivity $\sigma_x$ of the dielectric in a particular direction perpendicular to the principal surface and an electrical conductivity $\sigma_y$ of the dielectric in a direction perpendicular to the particular direction satisfy a relation $\sigma_x/\sigma_y \leq 0.01$.

According to the capacitor according to the first aspect, the electrical conductivity $\sigma_x$ of the dielectric in the particular direction perpendicular to the principal surface of the first electrode is much lower than the electrical conductivity $\sigma_y$ of the dielectric in the direction perpendicular to the particular direction. Therefore, current leakage in the capacitor is likely to be reduced.

According to a second aspect of the present disclosure, for example, in the capacitor according to the first aspect, the dielectric may be oriented in the particular direction. In this case, current leakage in the capacitor is likely to be reduced more reliably.

According to a third aspect of the present disclosure, for example, in the capacitor according to the first or second aspect, the dielectric may have a layered structure extending along the direction perpendicular to the particular direction. According to the third aspect, because of the layered structure of the dielectric, the electrical conductivity $\sigma_x$ of the dielectric in the particular direction tends to be much lower than the electrical conductivity $\sigma_y$ of the dielectric in the direction perpendicular to the particular direction.

According to a fourth aspect of the present disclosure, for example, in the capacitor according to the third aspect, the layered structure may include a first layer including a diamine and a second layer including tin(IV) sulfide, the second layer disposed alternately with the first layer. According to the fourth aspect, under application of voltage, a charge transfers in the second layer and the first layer prevents a charge from transferring. Consequently, the capacitor is likely to have a high capacitance.

According to a fifth aspect of the present disclosure, for example, in the capacitor according to the fourth aspect, the tin(IV) sulfide may be a single crystal. According to the fifth aspect, current leakage in the capacitor is likely to be reduced more reliably.

According to a sixth aspect of the present disclosure, for example, in the capacitor according to the fourth or fifth aspect, the diamine may be ethylenediamine. According to the sixth aspect, the first layer and the second layer are easily stacked alternately.

According to a seventh aspect of the present disclosure, for example, in the capacitor according to the third aspect, the layered structure may be formed of a layered double hydroxide. According to the seventh aspect, current leakage in the capacitor is likely to be reduced even when the layered structure is formed of the layered double hydroxide. Moreover, the capacitor is likely to have a high capacitance.

According to an eighth aspect of the present disclosure, for example, in the capacitor according to the seventh aspect, the layered double hydroxide may include a multidentate ligand. According to the eighth aspect, the capacitor is likely to have a high capacitance.

According to a ninth aspect of the present disclosure, for example, in the capacitor according to the eighth aspect, the multidentate ligand may include at least one selected from the group consisting of acetylacetone and a citrate. According to the ninth aspect, the capacitor is likely to have a high capacitance.

According to a tenth aspect of the present disclosure, for example, in the capacitor according to any one of the seventh to ninth aspects, the layered double hydroxide may include a transition metal. According to the tenth aspect, the capacitor is likely to have a high capacitance.

According to an eleventh aspect of the present disclosure, for example, in the capacitor according to the tenth aspect, the transition metal may include at least one selected from the group consisting of V, Cr, Mn, Fe, Co, Ni, Cu, W, and Ru. According to the eleventh aspect, the capacitor is likely to have a high capacitance.

According to a twelfth aspect of the present disclosure, for example, in the capacitor according to the tenth or eleventh aspect, the transition metal may be at least one selected from the group consisting of Ni and Fe. According to the twelfth aspect, the capacitor is likely to have a high capacitance.

According to a thirteenth aspect of the present disclosure, for example, the capacitor according to any one of the seventh to twelfth aspects, at least one selected from the group consisting of the first electrode and the second electrode may include a metal material. Moreover, the metal material may include at least one selected from the group consisting of V, Cr, Mn, Fe, Co, Ni, and Cu. According to the thirteenth aspect, the capacitor is likely to have a high capacitance.

According to a fourteenth aspect of the present disclosure, for example, in the capacitor according to the thirteenth aspect, the metal material may include Ni. According to the fourteenth aspect, the capacitor is likely to have a high capacitance.

According to a fifteenth aspect of the present disclosure, for example, in the capacitor according to any one of the first to fourteenth aspects, at least one selected from the group consisting of the first electrode and the second electrode may be a metal plate. According to the fifteenth aspect, a metal plate can be used as the electrode(s). Moreover, the capacitor is likely to have a high capacitance.

According to a sixteenth aspect of the present disclosure, for example, in the capacitor according to any one of the first to fifteenth aspects, the electrical conductivity $\sigma_x$ may be $1 \times 10^{-10}$ S/cm or less. According to the sixteenth aspect, current leakage in the capacitor is likely to be reduced more reliably.

An electrical circuit according to a seventeenth aspect of the present disclosure includes the capacitor according to any one of the first to sixteenth aspects. According to the seventeenth aspect, current leakage in the capacitor is likely to be reduced, and thus properties of the electrical circuit are likely to be improved.

A circuit board according to an eighteenth aspect of the present disclosure includes the capacitor according to any one of the first to sixteenth aspects. According to the eighteenth aspect, current leakage in the capacitor is likely to be reduced, and thus properties of the circuit board are likely to be improved.

An apparatus according to a nineteenth aspect of the present disclosure includes the capacitor according to any one of the first to sixteenth aspects. According to the nineteenth aspect, current leakage in the capacitor is likely to be reduced, and thus properties of the apparatus are likely to be improved.

Embodiments of the present disclosure will be described hereinafter with reference to the drawings. The present disclosure is not limited to the following embodiments.

(Embodiment 1)

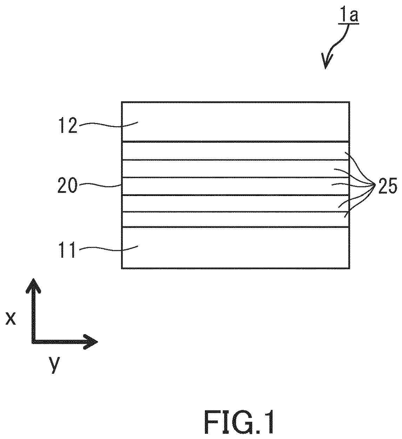

FIG. 1 schematically shows a capacitor 1a according to an example of the embodiment of the present disclosure. In FIG. 1, the x axis and the y axis are mutually orthogonal. As shown in FIG. 1, the capacitor 1a includes a first electrode 11, a second electrode 12, and a dielectric 20. The second electrode 12 is disposed to face a principal surface of the first electrode 11. The second electrode 12 is disposed in a particular direction (x axis direction) with respect to the principal surface of the first electrode 11. The dielectric 20 is disposed between the first electrode 11 and the second electrode 12 in the particular direction. The dielectric 20 is in contact with the first electrode 11 and the second electrode 12. For example, the dielectric 20 is in contact with the principal surface of the first electrode 11 and a principal surface of the second electrode 12. The principal surface of the second electrode 12 in contact with the dielectric 20 extends, for example, parallel to the principal surface of the first electrode 11 in contact with the dielectric 20. The principal surface of the first electrode 11 may be flat, or the principal surface of the first electrode 11 may have a step or fine asperities thereon. The principal surface of the first electrode 11 may be a surface of a porous body. An electrical conductivity $\sigma_x$ of the dielectric 20 in the particular direction perpendicular to the principal surface of the first electrode 11 and an electrical conductivity $\sigma_y$ of the dielectric 20 in a direction perpendicular to the particular direction satisfy a relation $\sigma_x/\sigma_y \leq 0.01$. As can be seen from this, the electrical conductivity $\sigma_x$ of the dielectric 20 is much lower than the electrical conductivity $\sigma_y$ of the dielectric 20. Therefore, current leakage in the capacitor 1a is likely to be reduced. The electrical conductivity $\sigma_x$ and the electrical conductivity $\sigma_y$ are each, for example, a measurement value at 25°C. When the principal surface of the first electrode 11 has a step or fine asperities thereon or when the principal surface of the first electrode 11 is a surface of a porous body, for example, the particular direction (x axis direction) may be determined assuming that a reference surface as defined in ISO 25178 is a surface parallel to the principal surface of the first electrode 11.

In the case of using a material having a large electrical conductivity anisotropy to form a dielectric of a capacitor, current leakage will be easily reduced if the degree of orientation in the dielectric can be increased in a direction in which the electrical conductivity of the material is lower. Meanwhile, in production of a capacitor such as a ceramic multilayer capacitor, a high pressure is sometimes applied to a dielectric to increase the density of the dielectric. Such application of a high pressure makes it difficult to increase the degree of orientation of the material in the dielectric. As just described, it is not easy to increase the degree of orientation in a dielectric of a capacitor in a direction in which the electrical conductivity of a material of the dielectric is lower. The present inventors have found a new finding that the degree of orientation of a material in a dielectric of a capacitor can be increased by drastic revision of capacitor production conditions. The capacitor 1a has been devised on the basis of this new finding.

The value of $\sigma_x/\sigma_y$ is desirably 0.008 or less, more desirably 0.006 or less, even more desirably 0.005 or less. The lower limit of $\sigma_x/\sigma_y$ is not limited to a particular value. The value of $\sigma_x/\sigma_y$ is, for example, 0.0001 or more.

The electrical conductivity $\sigma_x$ is not limited to a particular value as long as the relation $\sigma_x/\sigma_y \leq 0.01$ is satisfied in the dielectric 20. The electrical conductivity $\sigma_x$ is, for example, $1 \times 10^{-10}$ S/cm or less. In this case, current leakage in the capacitor 1a is likely to be reduced more reliably. The electrical conductivity $\sigma_x$ may be $2 \times 10^{-11}$ S/cm or less, $1 \times 10^{-11}$ S/cm or less, or $1 \times 10^{-14}$ S/cm or less.

As described above, the relation $\sigma_x/\sigma_y \leq 0.01$ is satisfied in the dielectric 20. In more details, the relation $\sigma_x/\sigma_y \leq 0.01$ may be satisfied at a frequency of 1 Hz, at frequencies of 0.0001 Hz or more and 3 Hz or less, or at frequencies of 0.1 Hz or more and 1 Hz or less.

The dielectric 20 is oriented, for example, in the particular direction. In other words, the dielectric 20 has a crystal structure oriented in the particular direction. Whether the dielectric 20 has this crystal structure can be confirmed, for example, on the basis of a peak in an XRD pattern obtained by X-ray diffraction (XRD) analysis of the dielectric 20. With such a structural feature, current leakage in the capacitor 1a is likely to be reduced more reliably. The dielectric 20 may have a crystal structure oriented only in the particular direction.

The dielectric 20 has, for example, a layered structure 25 extending along the direction perpendicular to the particular direction. In this case, the electrical conductivity $\sigma_x$ tends to be much lower than the electrical conductivity $\sigma_y$ in the dielectric 20. As a result, current leakage in the capacitor 1a is likely to be reduced more reliably.

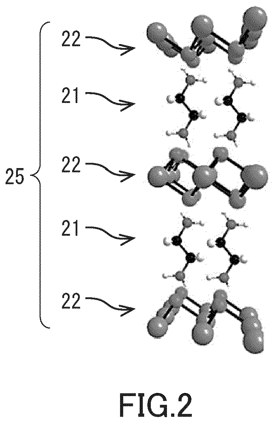

FIG. 2 shows an example of the layered structure 25 of the dielectric 20. The layered structure 25 includes, for example, a first layer 21 and a second layer 22. The first layer 21 and the second layer 22 are disposed alternately in the particular direction (x axis direction). For example, the alternate disposition may be alternate stacking of the first layer 21 and the second layer 22. The first layer 21 is a layer including a diamine. The second layer 22 is a layer including tin(IV) sulfide $SnS_2$. With such structural features, the $SnS_2$ responds to an electric field upon application of voltage and causes a charge to transfer in the second layer 22. At the same time, the first layer 21 prevents a charge from transferring. This is likely to increase the permittivity of the dielectric 20 and the capacitance of the capacitor 1a. The layered structure 25 can be formed, for example, by intercalation of a diamine between $SnS_2$ layers weakly bonded in the $SnS_2$ by van der Waals force.

The $SnS_2$ in the second layer 22 is, for example, a single crystal. With such a structural feature, current leakage in the capacitor 1a is likely to be reduced more reliably.

The diamine included in the first layer 21 is not limited to a particular diamine as long as the layered structure 25 can be formed. The diamine is, for example, an alkyldiamine or an aryldiamine. The number of carbon atoms in an alkyl group in the alkyldiamine or an aryl group in the aryldiamine is, for example, 10 or less, and may be 6 or less, 4 or less, or 3 or less. The diamine may include ethylenediamine. In this case, the first layer 21 and the second layer 22 are easily stacked alternately because intercalation of ethylenediamine into $SnS_2$ is relatively easy.

For example, the second layer 22 is disposed at each end of the layered structure 25 in the particular direction.

The materials of the first electrode 11 and the second electrode 12 in the capacitor 1a are not limited to particular materials. The first electrode 11 and the second electrode 12 each include, for example, a metal, an alloy, or an electrically conductive metal compound.

At least one selected from the group consisting of the first electrode 11 and the second electrode 12 may be a metal plate. Since a metal plate can be used as the electrode(s), the capacitor 1a is likely to have a high capacitance.

The method for producing the capacitor 1a is not limited to a particular method as long as the relation $\sigma_x/\sigma_y \leq 0.01$ is satisfied. The capacitor 1a can be produced, for example, by sandwiching the dielectric 20 between the first electrode 11 and the second electrode 12 and pressing the first electrode 11 and the second electrode 12 against the dielectric 20. In this case, the pressure applied to the dielectric 20 is adjusted to a given value or lower. The pressure applied to the dielectric 20 is adjusted, for example, to 1 MPa or less. This maintains a large electrical conductivity anisotropy of the dielectric 20, and the value of $\sigma_x/\sigma_y$ is likely to be adjusted in a desired range. The pressure applied to the dielectric 20 is desirably adjusted to 0.5 MPa or less, and is more desirably adjusted to 0.1 MPa or less.

The first electrode 11 and the second electrode 12 may be formed on the principal surfaces of the dielectric 20 by a vacuum process, plating, coating, or the like. This maintains a large electrical conductivity anisotropy of the dielectric 20, and the value of $\sigma_x/\sigma_y$ is likely to be adjusted in a desired range. Examples of the vacuum process include vacuum deposition, DC sputtering, RF magnetron sputtering, pulsed laser deposition (PLD), atomic layer deposition (ALD), and chemical vapor deposition (CVD).

(Embodiment 2)

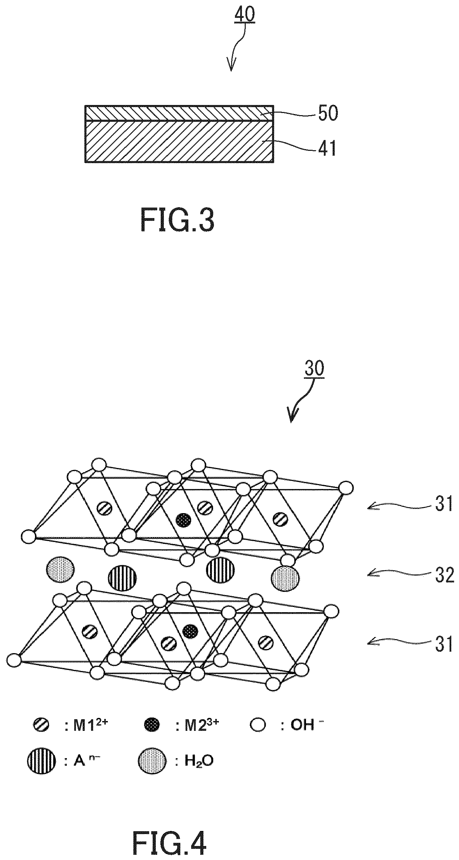

The layered structure 25 may be formed of a layered double hydroxide (LDH). FIG. 3 is a cross-sectional view schematically showing a dielectric-including member 40 according to an example of the present embodiment. As shown in FIG. 3, the dielectric-including member 40 includes an electrode 41 and a dielectric 50. The electrode 41 may be the first electrode 11 or the second electrode 12 described in Embodiment 1. The dielectric 50 includes an LDH. The LDH is in contact with the electrode 41. The dielectric 50 is provided, for example, in direct contact with a surface of the electrode 41. Therefore, the dielectric-including member 40 is advantageous in terms of increasing the capacitance of a capacitor. Additionally, since the layered structure 25 is formed of the LDH, current leakage in the capacitor is likely to be reduced.

FIG. 4 schematically shows an example of a crystal structure of an LDH 30. The LDH 30 includes, for example, OH groups present on surfaces of metal hydroxide layers and a negatively charged molecule, such as an anion, inserted between the layers. The LDH 30 has a composition, for example, represented by $[M1^{2+}_{1-x}M2^{3+}_x(OH)_2][yA^{n-}\cdot mH_2O]$. In this composition, $M1^{2+}$ is a divalent metal ion. The symbol $M2^{3+}$ is a trivalent metal ion. The symbol $A^{n-}$ is an anion between the layers. The symbol x is a rational number satisfying a requirement $0 < x < 1$. The symbol y is a number needed to achieve charge balance. The symbol n is an integer. The symbol m is a proper rational number.

The LDH 30 may include, for example, an ion of a transition metal as each metal ion. The LDH 30 may include at least one selected from the group consisting of V, Cr, Mn, Fe, Co, Ni, Cu, W, and Ru as the transition metal. With such a feature, the capacitor 1a is likely to have a high capacitance.

The LDH 30 may include at least one selected from the group consisting of Ni and Fe as the transition metal. With such a feature, the capacitor 1a is likely to have a high capacitance.

A crystallite size of the LDH 30 in a stacking direction may be 10 nm or less, or 5 nm or less. The lower limit of the crystallite size of the LDH 30 in the stacking direction is not limited to a particular value. The lower limit thereof may be 1.5 nm or 2 nm. The term "stacking direction" refers to, for example, the particular direction (x axis direction). The crystallite size of the LDH 30 in the stacking direction can be determined, for example, using an X-ray diffractometer (XRD).

The LDH 30 has, for example, a hexagonal crystallite in a plane direction. A crystallite size of the LDH 30 in the plane direction may be 10 nm or less, or 5 nm or less. The lower limit of crystallite size of the LDH 30 in the plane direction is not limited to a particular value. The lower limit thereof may be 1.5 nm or less, or 2 nm or less. The term "plane direction" refers to, for example, a direction perpendicular to the stacking direction. The crystallite size of the LDH 30 in the stacking direction and the crystallite size of the LDH 30 in the plane direction may be the same or may be different. A difference between the crystallite size of the LDH 30 in the stacking direction and the crystallite size of the LDH 30 in the plane direction is, for example, 5 nm or less. The crystallite size of the LDH 30 in the plane direction can be determined, for example, using an X-ray diffractometer (XRD). In the present disclosure, the term "crystallite size" refers to a crystallite size of the LDH 30 in the stacking direction or the plane direction, the crystallite size being determined by an XRD result and the Scherrer equation.

The anion $A^{n-}$ may be an inorganic ion or an organic ion. Examples of the inorganic ion include $CO_3^{2-}$, $NO_3^-$, $Cl^-$, $SO_4^{2-}$, $Br^-$, $OH^-$, $F^-$, $I^-$, $Si_2O_5^{2-}$, $B_4O_5(OH)_4^{2-}$, and $PO_4^{3-}$. Examples of the organic ion include $CH_3(CH_2)_aSO_3^-$, $CH_3(CH_2)_aCOO^-$, $CH_3(CH_2)_aPO_4^-$, and $CH_3(CH_2)_aNO_3^-$. Here, a is an integer of 0 or greater. The anion $A^{n-}$ is an anion inserted between the metal hydroxide layers along with a water molecule. The electric charge of the anion $A^{n-}$ and the ionic size thereof are not limited to particular values. The LDH 30 may include one type of $A^{n-}$, or may include two or more types of $A^{n-}$.

As shown in FIG. 4, the LDH 30 has $OH^-$ at each vertex of an octahedron having the metal ion $M1^{2+}$ or $M2^{3+}$ at its center. A metal hydroxide is represented by $[M1^{2+}_{1-x}M2^{3+}x(OH)_2]^{x+}$. The metal hydroxide has a layered structure in which hydroxide octahedrons share their ridges to be connected two-dimensionally. The anion and the water molecule are positioned between the metal hydroxide layers. The metal hydroxide layers each function as a host layer 31, and the anion and the water molecule are inserted therebetween as a guest layer 32. That is, the LDH 30 as a whole has a layered structure in which the host layer 31 being the metal hydroxide and the guest layer 32 being the anion and the water molecule are alternately stacked. The LDH 30 has a structure in which one or some of the metal ions $M1^{2+}$ included in the metal hydroxide layers are each substituted by the metal ion $M2^{3+}$. Accordingly, a surface of the LDH 30 is commonly positively charged.

The LDH 30 may include a multidentate ligand. In this case, the multidentate ligand may coordinate to each metal ion in the LDH 30. This makes it likely to achieve a dielectric-including member in which a large portion of the surface of the electrode 41 is covered with the LDH 30. Additionally, the dispersion stability of the LDH 30 can be improved further. Moreover, when the LDH 30 includes the multidentate ligand, a particle diameter of the LDH 30 tends to be small. Consequently, a thickness of the dielectric 50 including the LDH 30 is easily decreased and the capacitance of a capacitor is easily improved.

The multidentate ligand is not limited to a particular multidentate ligand. The multidentate ligand is, for example, an organic compound coordinating to the metal in the LDH 30. The multidentate ligand may be at least one selected from the group consisting of a bidentate organic ligand and a tridentate organic ligand. Examples of the multidentate ligand include β-diketones, β-ketoesters, and hydroxycarboxylic acids. Examples of the β-diketones include acetylacetone (ACAC), trifluoroacetylacetone, hexafluoroacetylacetone, benzoylacetone, thenoyltrifluoroacetone, dipivaloyl methane, dibenzoylmethane, and ascorbic acid. Examples of the β-ketoesters include methyl acetoacetate, ethyl acetoacetate, allyl acetoacetate, benzyl acetoacetate, n-propyl acetoacetate, isopropyl acetoacetate, n-butyl acetoacetate, iso-butyl acetoacetate, tert-butyl acetoacetate, 2-methoxyethyl acetoacetate, and methyl 3-oxopentanoate. Examples of the hydroxycarboxylic acids and salts thereof include tartaric acid, citric acid, malic acid, gluconic acid, ferulic acid, lactic acid, glucuronic acid, and salts thereof. The multidentate ligand may include at least one selected from the group consisting of acetylacetone and trisodium citrate. The multidentate ligand may include at least one selected from the group consisting of acetylacetone and a citrate.

Whether the LDH 30 includes the multidentate ligand can be judged, for example, by examining an ultraviolet-visible absorption spectrum of the LDH 30 by ultraviolet-visible absorbance measurement (UV-vis). For example, when the multidentate ligand is acetylacetone (ACAC), an absorption peak derived from ACAC is observed around 300 nm by UV-Vis.

When the layered structure 25 is formed of the LDH, the electrode 41 may include a metal material. That is, at least one selected from the group consisting of the first electrode 11 and the second electrode 12 may include a metal material. The metal material typically has electrical conductivity. The metal material may include at least one selected from the group consisting of V, Cr, Mn, Fe, Co, Ni, and Cu. The metal material may include Ni. In this way, the capacitor 1a is likely to have a high capacitance.

When the layered structure 25 is formed of the LDH 30, the electrode 41 may be a metal plate. That is, at least one selected from the group consisting of the first electrode 11 and the second electrode 12 may be a metal plate. The capacitor 1a is likely to have a high capacitance because a metal plate can be used as its electrode(s).

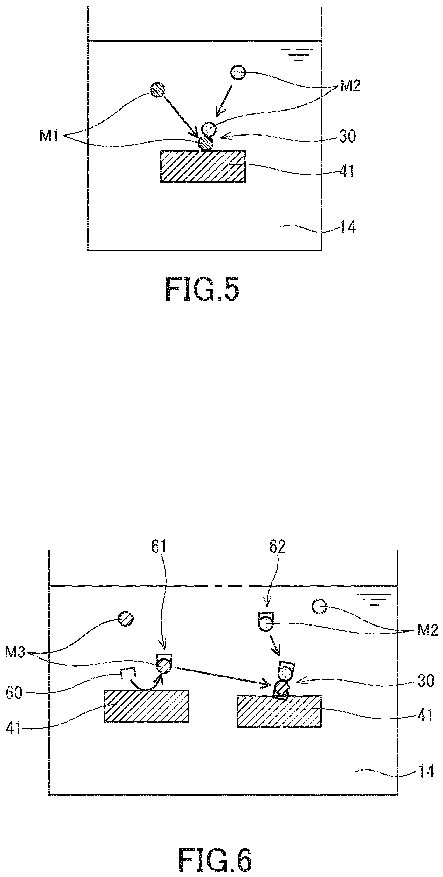

When the layered structure 25 is formed of the LDH 30, the method for producing the dielectric-including member 40 is not limited to a particular method. FIG. 5 schematically shows an exemplary mechanism to produce the dielectric-including member 40. In a state where the electrode 41 including the metal material is present in a liquid 14 containing metal ions M1 and M2, the pH of the liquid 14 is increased to generate the LDH 30. In this manner, the layered structure 25 including the LDH 30 and being in contact with the electrode 41 can be formed, and thus the dielectric-including member 40 can be produced.

For the generation of the LDH 30, for example, the liquid 14 is adjusted to alkaline at ordinary temperature. That is, the pH of the liquid 14 is increased at ordinary temperature. This makes it possible to generate the LDH 30 more reliably. Incidentally, the term "ordinary temperature" refers to a temperature range of $20°C \pm 15°C$, as defined in Japanese Industrial Standards (JIS) Z 8703.

Each metal ion contained in the liquid 14 may include an ion of at least one metal selected from the group consisting of V, Cr, Mn, Fe, Co, Ni, Cu, W, and Ru. With such a feature, a large portion of the surface of the electrode 41 is likely to be covered with the LDH 30 in the dielectric-including member 40.

Each metal ion contained in the liquid 14 may include an ion of at least one metal selected from the group consisting of Ni and Fe. With such a feature, a large portion of the surface of the electrode 41 is likely to be covered with the LDH 30 in the dielectric-including member 40.

The metal material included in the electrode 41 may include at least one selected from the group consisting of V, Cr, Mn, Fe, Co, Ni, and Cu. With such a feature, a large portion of the surface of the electrode 41 is likely to be covered with the LDH 30 in the dielectric-including member 40.

The metal material included in the electrode 41 may include Ni. With such a feature, a large portion of the surface of the electrode 41 is likely to be covered with the LDH 30 in the dielectric-including member 40.

The electrode 41 may be a metal plate. Since a metal plate can be used as the electrode 41, a large portion of the surface of the electrode 41 is likely to be covered with the LDH 30.

FIG. 6 schematically shows another exemplary mechanism to produce the dielectric-including member 40. The method for producing the dielectric-including member 40 based on the mechanism shown in FIG. 6 is the same as the production method based on the mechanism shown in FIG. 5, unless otherwise described. In these production methods, the same or correspond components are denoted by the same reference characters, and detailed descriptions of such components are omitted.

First, the liquid 14 containing the metal ion M2 and a multidentate ligand 60 is prepared, and then the electrode 41 is disposed in the liquid 14. Next, in a state where the electrode 41 is present in the liquid 14, for example, the liquid 14 is made alkaline at ordinary temperature. That means the pH of the liquid 14 is increased. During this process, one multidentate ligand 60 reacts with the metal material included in the electrode 41 to form a complex 61 of the multidentate ligand 60 and a metal ion M3 included in the electrode 41. Moreover, a complex 62 of another multidentate ligand 60 and the metal ion M2 in the liquid 14 is also formed in the liquid 14. Subsequently, the complexes 61 and 62 react with each other on the surface of the electrode 41 to generate the LDH 30 on the surface of the electrode 41. In this manner, the LDH 30 is disposed in contact with the surface of the electrode 41. Furthermore, since the complexes 61 and 62 include the multidentate ligand 60, crystal growth of the LDH 30 is reduced. In this manner, the dielectric layer 50 including the LDH 30 is formed on the surface of the electrode 41, and the dielectric-including member 40 is obtained. Alternatively, the LDH 30 may be generated by a reaction of the complexes 61 and 62 in the liquid 14. The dielectric layer 50 including the LDH 30 may be formed by disposing the thus-generated LDH 30 in contact with the surface of the electrode 41.

As shown in FIG. 6, in the production of the dielectric-including member 40, the liquid 14 may contain the multidentate ligand 60. In this case, a proportion of a portion of the surface of the electrode 41 is likely to increase, the portion being covered with the LDH 30. For example, the above-described multidentate ligand can be used as the multidentate ligand 60. In the production of the dielectric-including member 40, the multidentate ligand 60 may include at least one selected from the group consisting of acetylacetone and a citrate. In this case, a large portion of the surface of the electrode 41 is likely to be covered with the LDH 30.

The metal ion and the multidentate ligand may be added to the liquid 14 in no particular order. The method for adjusting the pH to a value greater than 7, namely, the method for adjusting the liquid 14 to alkaline, is not limited to a particular method. For example, the liquid 14 may be adjusted to alkaline by mixing an aqueous solution containing the metal ion and the multidentate ligand and an aqueous alkaline solution. Alternatively, the pH of the liquid 14 may be adjusted by adding a pH increasing agent to an aqueous solution containing the metal ion and the multidentate ligand. The pH increasing agent is not limited to a particular compound. The pH increasing agent includes, for example, an epoxy group. Examples of the pH increasing agent include propylene oxide, ethylene oxide, and butylene oxide.

The pH increasing agent, such as propylene oxide, includes an epoxy group. The pH increasing agent, such as propylene oxide, added into the liquid 14 can capture hydrogen ions in the liquid 14 under the presence of a nucleophile such a chloride ion with progression of a ring-opening reaction of the epoxy group. Consequently, the pH of the liquid 14 increases, and the acidic liquid 14 turns alkaline. That is, the pH of the liquid 14 increases, and the liquid 14 can become alkaline. The pH of the liquid 14 containing the metal ion and the multidentate ligand is, for example, 1. Addition of the pH increasing agent to this liquid 14, for example, causes the pH of the liquid 14 to gradually increase from 1, and eventually the liquid 14 can be alkaline. The pH of the liquid 14 at the time is, for example, 8 or more and 12 or less.

In the method for producing the dielectric-including member 40 of present embodiment, the pH of the above alkaline liquid 14 may be further increased. The pH may be increased gradually.

An example of the method for further increasing the pH of the above alkaline liquid 14 is a method in which an aqueous alkaline solution is added into the liquid 14 containing the metal ion and the multidentate ligand. Alternatively, the pH increasing agent added in the liquid 14 containing the metal ion and the multidentate ligand can increase the pH of the liquid 14. The addition of the pH increasing agent into the liquid 14 causes a reaction for capturing hydrogen ions in the liquid 14. Consequently, the pH of the liquid 14 gradually increases. A period of time required for the pH of the liquid 14 to increase and reach a steady state is, for example, 24 hours or longer, and can be, for example, several days. When the pH of the liquid 14 increases and then reaches the steady state, the pH of the liquid 14 is, for example, 8 or more and 12 or less.

In the production of the dielectric-including member 40, the metal ion and the multidentate ligand contained in the liquid 14 form, for example, a complex whose solubility in water at 20°C to 25°C is 2 grams/liter or more. That is, in the production of the dielectric-including member 40, the solubilities of the complexes 61 and 62 in water at 20°C to 25°C are, for example, 2 grams/liter or more each. Such concentrations allow the complexes 61 and 62 formed of the multidentate ligand to easily disperse in the liquid and are thus advantageous in terms of LDH generation. The solubilities of the complexes 61 and 62 in water can be determined, for example, with reference to a database such as Chemical Book.

The present inventors think that appropriate adjustment of the multidentate ligand 60 concentration in the liquid 14 facilitates the reaction between the complexes 61 and 62. Specifically, the present inventors think that appropriate adjustment of the multidentate ligand 60 concentration in the liquid 14 facilitates the reaction between the metal ion M3 in the complex 61 and the metal ion M2 in the complex 62, so that the LDH 30 is easily generated. For example, the presence of an excessive amount of the multidentate ligand 60 in the liquid 14 tends to promote the reaction between the multidentate ligand 60 and the metal ion M3 or the reaction between the multidentate ligand 60 and the metal ion M2. This can slow down the rate of the reaction between the metal ion M3 included in the complex 61 and the metal ion M2 included in the complex 62. This is thought to hinder generation of the LDH 30 in the liquid 14. According to the method for producing the dielectric-including member 40 according to the present embodiment, for example, the multidentate ligand 60 concentration in the liquid 14 is appropriately adjusted, which makes easy generation of the LDH 30 possible.

According to the method for producing the dielectric-including member 40, a ratio v of the multidentate ligand 60 concentration in the liquid 14 to the total metal ion concentration in the liquid 14 is, for example, 0.4 or less. That is, in the production of the dielectric-including member 40, the ratio v of the multidentate ligand 60 concentration in the liquid 14 to the total concentration of the metal ions M2 and M3 in the liquid 14 is, for example, 0.4 or less. This is likely to increase the capacitance of a capacitor configured using the dielectric-including member 40. The ratio v may be 0.2 or more and 0.5 or less, or 0.25 or more and 0.45 or less.

A member for capacitors can be provided, the member including the dielectric-including member 40 according to the present embodiment. The electrode 41 in the dielectric-including member 40 can function, for example, as an anode or a cathode of a capacitor.

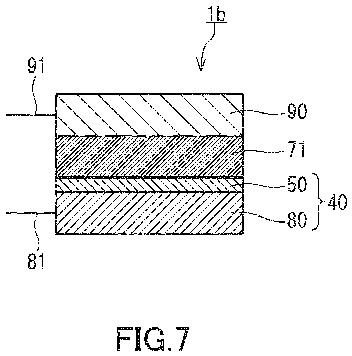

FIG. 7 schematically shows another example of the capacitor according to the embodiment of the present disclosure.

A capacitor 1b includes a separator 71, a first electrode 80, a second electrode 90, a first lead terminal 81, and a second lead terminal 91. The separator 71 is disposed, for example, between the first electrode 80 and the second electrode 90, and separates the first electrode 80 and the second electrode 90. The first lead terminal 81 is connected, for example, to the first electrode 80. The second lead terminal 91 is connected, for example, to the second electrode 90.

The dielectric-including member 40 includes the first electrode 80 and the dielectric 50 provided on a principal surface of the first electrode 80. The first electrode 80 includes the electrode 41 as described in Embodiment 1. The term "principal surface" of the first electrode 80 refers to a surface of the first electrode 80, the surface having the largest area. The term "principal surface" of the first electrode 80 can include a surface of the first electrode 80, the surface facing the second electrode 90. The principal surface of the first electrode 80 may be covered by the dielectric 50. The dielectric 50 includes the LDH 30 as described above. The dielectric 50 is disposed, for example, between the first electrode 80 and the separator 71.

According to the above configuration, the capacitor 1b includes the dielectric-including member 40, and thus can have a high capacity.

(Embodiment 3)

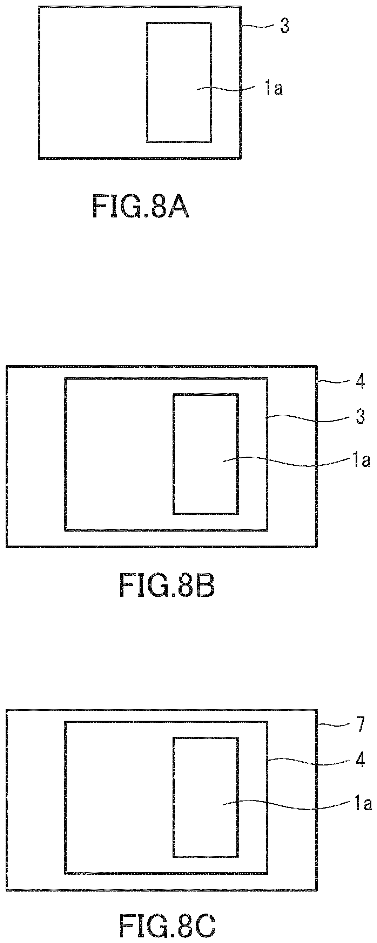

FIG. 8A schematically shows an electrical circuit 3 according to the embodiment of the present disclosure. As shown in FIG. 8A, the electrical circuit 3 includes the capacitor 1a described in Embodiment 1. The electrical circuit 3 is not limited to a particular circuit. The electrical circuit 3 may be an active circuit or a passive circuit. The electrical circuit 3 may be a discharging circuit, a smoothing circuit, a decoupling circuit, or a coupling circuit. Since the electrical circuit 3 includes the capacitor 1a, the electrical circuit 3 is likely to have desired properties. For example, it is likely that the capacitor 1a reduces noise in the electrical circuit 3. The electrical circuit 3 may include the capacitor 1b described in Embodiment 2 instead of the capacitor 1a.

FIG. 8B schematically shows a circuit board 4 according to the embodiment of the present disclosure. As shown in FIG. 8B, the circuit board 4 includes the capacitor 1a described in Embodiment 1. The circuit board 4 is not limited to a particular circuit board. The circuit board 4 includes, for example, the electrical circuit 3. The circuit board 4 may be an embedded board or a motherboard. The circuit board 4 may include the capacitor 1b described in Embodiment 2 instead of the capacitor 1a.

FIG. 8C schematically shows an apparatus 7 according to the embodiment of the present disclosure. As shown in FIG. 8C, the apparatus 7 includes the capacitor 1a described in Embodiment 1. The apparatus 7 is not limited to a particular apparatus. The apparatus 7 includes, for example, the circuit board 4. The apparatus 7 may be an electronic device, a communication device, a signal-processing device, or a power-supply device. The apparatus 7 may be a server, an AC adapter, an accelerator, or a flat-panel display such as a liquid crystal display (LCD). The apparatus 7 may be a USB charger, a solid-state drive (SSD), an information terminal such as a PC, a smartphone, or a tablet PC, or an Ethernet switch. The apparatus 7 may include the capacitor 1b described in Embodiment 2 instead of the capacitor 1a.

EXAMPLES

Hereinafter, the present disclosure will be described in more detail with reference to examples. The examples given below are just examples, and the present disclosure is not limited to them.

(Example 1)

One end of a quartz glass tube manufactured by QSIL GmbH was molten using a gas burner to be closed. The quartz glass tube was cut to a length of about 20 cm. A glass container was produced in this manner. The quartz glass tube had an outer diameter of 13 mm and a wall thickness of 1.25 mm. A desiccation treatment was performed by heating the glass container in an environment decompressed to 10 Pa or lower with a rotary pump and having a temperature of about 300°C. According to "Gas emission from quartz glass" reported by Nasu, et al. in Journal of the Illuminating Engineering Institute of Japan, vol. 74, no. 9, pp. 595 to 600, it is assumed that approximately $7.31 \times 10^{-9}$ mol of moisture was removed by this desiccation treatment. The glass container having undergone the desiccation treatment was closed with a rubber stopper and transferred into a glove box. Inside the glove box, approximately 0.2 g of single-crystal $SnS_2$ and 4 milliliters (ml) of ethylenediamine were put in the glass container, which was then closed with a rubber stopper so that external air would not enter. Then, the glass container was taken out of the glove box. The single-crystal $SnS_2$ used was provided by HQ graphene or 2D semiconductors. The ethylenediamine used was provided by FUJIFILM Wako Pure Chemical Corporation. The grade of the ethylenediamine used was Wako Special Grade.

After cooled in liquid nitrogen, the glass container containing the single-crystal $SnS_2$ and the ethylenediamine was left in an environment decompressed to 10 Pa or lower with a rotary pump. The boiling point of liquid nitrogen is -196°C. Under the above condition, the vacuum at 10 Pa or lower was maintained for 5 minutes to remove moisture. After that, a vicinity of the opening of the glass container was molten using a burner to close the glass container. Then, the glass container was heated in an environment at 140°C to 220°C to intercalate the ethylenediamine into the single-crystal $SnS_2$. The reaction product in the glass container was taken out, and an unreacted ethylenediamine was removed to obtain a sample according to Example 1.

(X-ray diffraction measurement)

An X-ray diffraction (XRD) pattern of the sample according to Example 1 by 2θ/θ scan was obtained using an X-ray diffractometer X'Pert Pro manufactured by PANalytical B.V. Additionally, an XRD pattern of single-crystal $SnS_2$ was obtained using a specimen in which a plate-shaped single-crystal $SnS_2$ was on a glass sheet. A Cu-Kα ray was used as an X-ray source, the voltage was adjusted to 45 kV, the current was adjusted to 40 mA, and the scanning speed was adjusted to 12 deg/min. To see positions of X-ray diffraction peaks, an XRD pattern of single-crystal $SnS_2$ and an XRD pattern of a material obtained by intercalation of ethylenediamine into single-crystal $SnS_2$ were calculated using RIETAN FP (F. Izumi and K. Momma, Solid State Phenom., 130, 15-20 (2007).). In the calculation of the XRD patterns, it is assumed that ethylenediamine and $SnS_2$ are perfectly oriented.

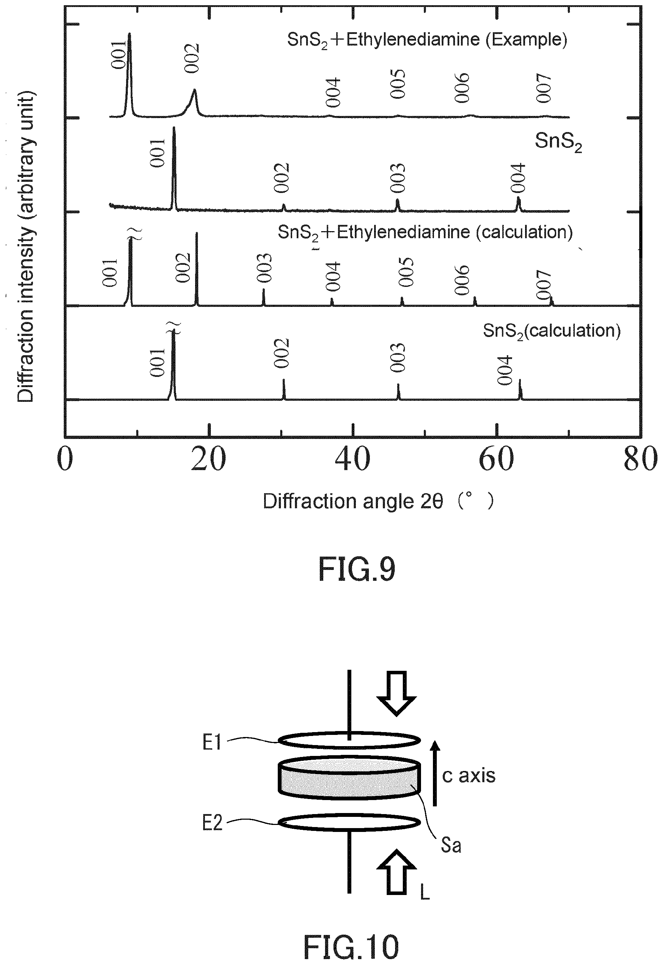

FIG. 9 shows results of measuring and calculating the XRD patterns of the single-crystal $SnS_2$ and the sample according to Example 1. In FIG. 9, the vertical axis represents the diffraction intensity, while the horizontal axis represents the diffraction angle. The XRD pattern shown at the top of FIG. 9 is the XRD pattern of the sample according to Example 1. The second XRD pattern from the top of FIG. 9 is the XRD pattern of the single-crystal $SnS_2$. The second XRD pattern from the bottom of FIG. 9 is the result of calculating the XRD pattern of the perfectly-oriented material obtained by intercalation of ethylenediamine into single-crystal $SnS_2$. The XRD pattern shown at the bottom of FIG. 9 is the result of calculating the XRD pattern of the single-crystal $SnS_2$. In the results of calculating the XRD patterns, no diffraction peaks except for a peak from the c axis are confirmed for both the perfectly-oriented material obtained by intercalation of ethylenediamine into single-crystal $SnS_2$ and the single-crystal $SnS_2$. It is understood that only a peak derived from the (00l) plane is confirmed in both calculation results. The symbol l is an integer of 1 or greater.

In the results for measuring the XRD patterns of the sample according to Example 1 and the single-crystal $SnS_2$, as in the calculation results, only a peak derived from the (00l) plane is confirmed. This indicates a high degree of orientation in the sample according to Example 1.

(AC impedance measurement)

FIG. 10 shows a method for producing a specimen for AC impedance measurement of the sample according to Example 1. As shown in FIG. 10, the sample Sa according to Example 1 was sandwiched between an electrode E1 and an electrode E2, and was pressurized at a pressure L of 0.04 MPa to produce a specimen for AC impedance measurement. A four-terminal sample holder SH2-Z manufactured by TOYO Corporation was used as the electrode E1 and the electrode E2. The electrode E1 and the electrode E2 each had a diameter of 2.5 mm. The sample according to Example 1 had a thickness of 0.53 mm.

An impedance analyzer was configured by combining a frequency response analyzer Model 1260A and a potentiostat Model 1287A manufactured by Solartron Analytical. AC impedance measurement was performed for the specimen for AC impedance measurement using this impedance analyzer. In this measurement, a 100 mV voltage was applied in the frequency range of $10^{-1}$ to $10^5$ Hz. The environment temperature was 25°C in this measurement.

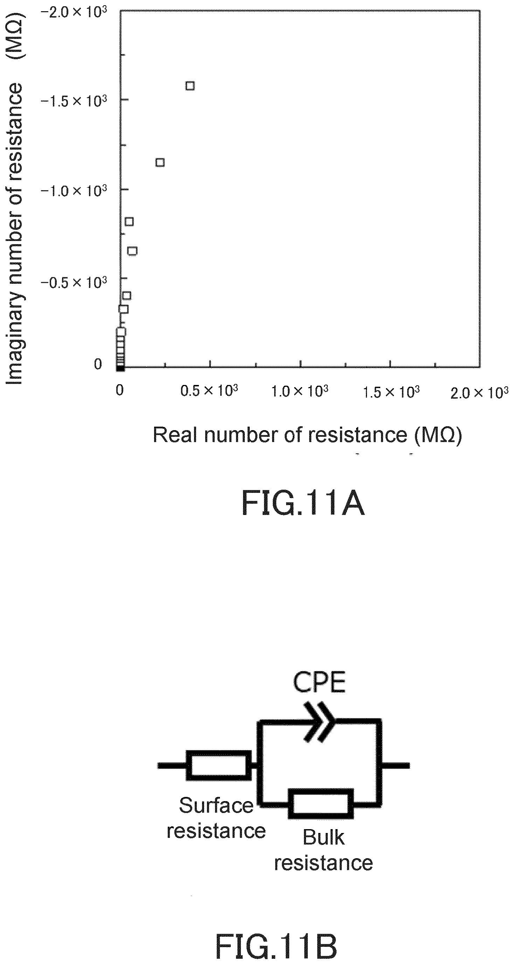

FIGS. 11A and 11B respectively show a Nyquist plot obtained from the result of the AC impedance measurement for the specimen according to Example 1 and an equivalent circuit used for fitting. In FIG. 11A, the vertical axis represents the imaginary number of a resistance, while the horizontal axis represents the real number of the resistance. Additionally, a hollow symbol represents an actual value. Table 1 shows values determined for components by the fitting using the equivalent circuit shown in FIG. 11B.

A Nyquist plot of an ideal capacitor is a vertical straight line. On the other hand, when the amount of current leakage increases, a Nyquist plot shows an arc-shaped locus. While the Nyquist plot shown in FIG. 6 of Non Patent Literature 1 shows an arc-shaped locus, the Nyquist plot of the specimen according to Example 1 is linear. While the magnitude of the arc in the Nyquist plot of Non Patent Literature 1 is approximately 25 MΩ, a bulk resistance of the equivalent circuit used for fitting for the specimen according to Example 1 is large, namely, 11 GΩ. A large bulk resistance facilitates reduction in current leakage.

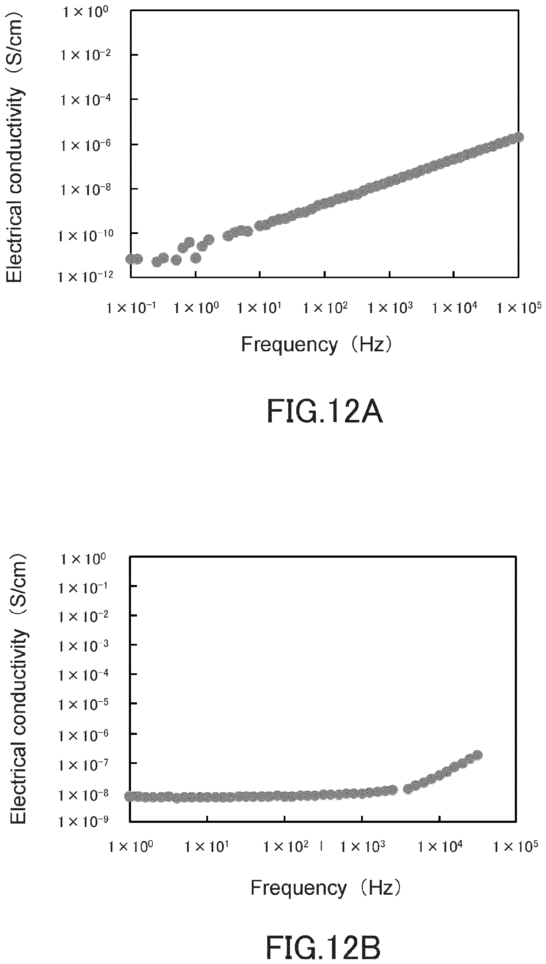

FIG. 12A is a graph showing a relation between an electrical conductivity of the specimen according to Example 1 in a thickness direction thereof and the frequency of the AC voltage. In FIG. 12A, the vertical axis represents the electrical conductivity, the horizontal axis represents the frequency. FIG. 12B is a graph showing a relation between an electrical conductivity of the specimen according to Example 1 in an in-plane direction thereof and the frequency of the AC voltage. Four separate terminals were formed using a silver paste (TK paste) manufactured by KAKEN TECH Co., Ltd. on a sample produced in the same manner as in Example 1. The sample was measured for its electrical conductivity by AC four-terminal sensing. Probes were attached to these four terminals to measure the electrical conductivity in the in-plane direction in the same manner as in Example 1. In FIG. 12B, the vertical axis represents the electrical conductivity, while the horizontal axis represents the frequency. According to FIG. 12A, the electrical conductivity of the specimen according to Example 1 in the thickness direction is above the lower limit at a frequency of $10^{-1}$ Hz. Therefore, it is understood that an electrical conductivity of the specimen according to Example 1 in the thickness direction under DC voltage is less than $2 \times 10^{-11}$ S/cm. According to Non Patent Literature 1, a bulk electrical conductivity of the sample at room temperature is approximately $7 \times 10^{-9}$ S/cm. Furthermore, according to Wentao Qin, et. al. "A Latent Issue of Via Resistance: Mechanism and Solution." ISTFA 2018: (2018): 121-127, amorphous tantalum oxide $Ta_2O_5$ used as a dielectric of a capacitor has an electrical conductivity of around $10^{-8}$ S/cm. It is understood that current leakage is considerably reduced in the specimen according to Example 1

On the other hand, according to FIG. 12B, the electrical conductivity of the specimen according to Example 1 in the in-plane direction at $10^3$ Hz or less is saturated at approximately $6 \times 10^{-9}$ S/cm. Therefore, it is understood that a ratio of the electrical conductivity of the specimen according to Example 1 in the thickness direction under DC voltage to an electrical conductivity thereof in the in-plane direction under DC voltage is approximately 0.003.

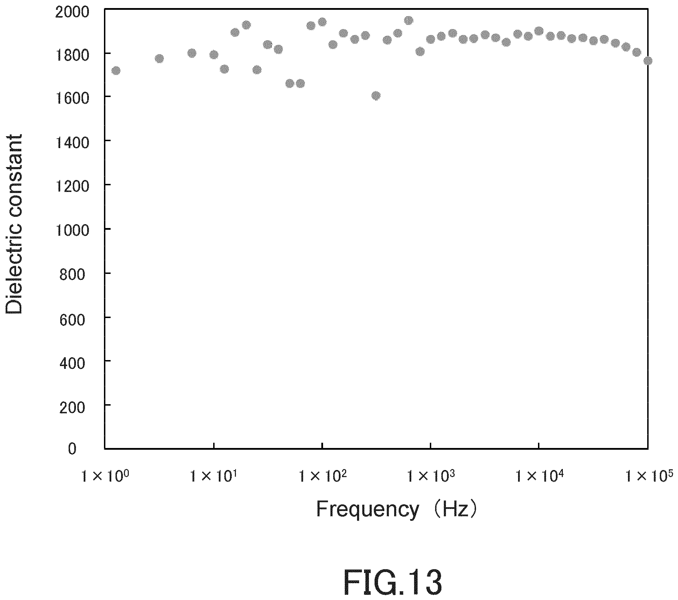

FIG. 13 is a graph showing a relation between a dielectric constant of the specimen according to Example 1 and the frequency of the AC voltage. In FIG. 13, the vertical axis represents the dielectric constant, while the horizontal axis represents the frequency. According to FIG. 13, dielectric relaxation is not confirmed in the frequency range of 1 Hz to $1 \times 10^5$ Hz, and the dielectric constant of the specimen according to Example 1 in this frequency range is roughly 1800. This value is comparable with a dielectric constant of $BaTiO_3$ used as a dielectric of a capacitor. It is understood that the sample according to Example 1 is very useful as a dielectric of a capacitor.

(Comparative Example 1)

A sample according to Comparative Example 1 was produced in the same manner as in Example 1, except that 0.5 g of a $SnS_2$ powder was used instead of 0.2 g of single-crystal $SnS_2$. The supplier of the $SnS_2$ powder is KOJUNDO CHEMICAL LABORATORY CO., LTD., and the purity of the $SnS_2$ powder is 3 Nup.

(AC impedance measurement)

A specimen according to Comparative Example 1 for AC impedance measurement was produced in the same manner as in Example 1, except that the sample according to Comparative Example 1 was used instead of the sample according to Example 1 and the value of the pressure L was changed to 2.72 MPa to shape the sample into a pellet. The electrodes had a diameter of 10 mm, and the pellet-shaped specimen had a thickness of 0.99 mm. AC impedance measurement was performed for this specimen in the same manner as in Example 1. Since this specimen was obtained by shaping the powdery sample into a pellet, the specimen is thought to have random crystal orientations. In other words, this specimen is thought to be in a non-oriented state.

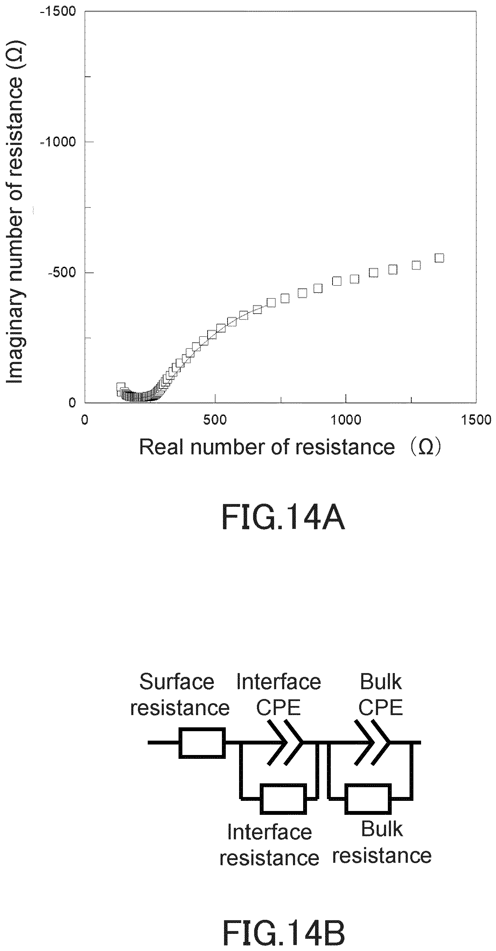

FIGS. 14A and 14B respectively show a Nyquist plot obtained from the result of the AC impedance measurement for the specimen according to Comparative Example 1 and an equivalent circuit used for fitting. In FIG. 14A, the vertical axis represents the imaginary number of a resistance, while the horizontal axis represents the real number of the resistance. In FIG. 14A, a hollow symbol represents an actual value, while a solid line represents the fitting result. Table 1 shows values determined for components by the fitting using the equivalent circuit shown in FIG. 14B.

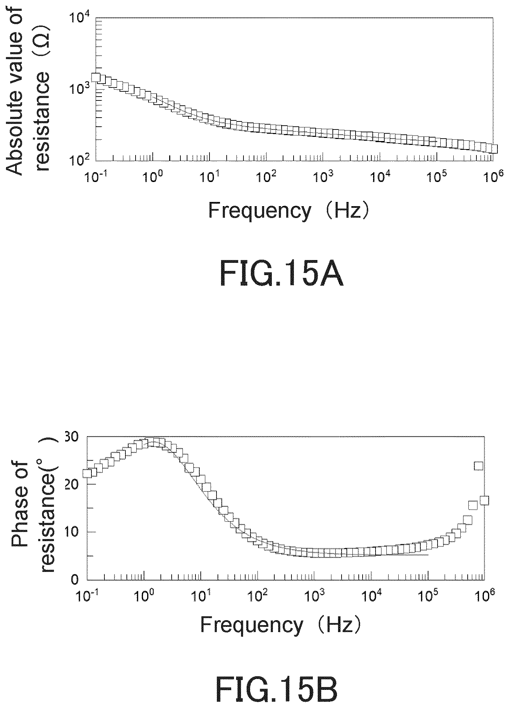

FIG. 15A is a Bode plot showing a relation between an absolute value of the resistance of the specimen according to Comparative Example 1 and the frequency of the AC voltage. In FIG. 15A, the vertical axis represents the absolute value of the resistance, while the horizontal axis represents the frequency. FIG. 15B is a Bode plot showing a relation between a phase of the resistance of the specimen according to Comparative Example 1 and the frequency of the AC voltage. In FIG. 15B, the vertical axis represents the phase of the resistance, while the horizontal axis represents the frequency. In FIGS. 15A and 15B, a hollow symbol represents an actual value, while a solid line represents the fitting result.

The fitting results coincide with the actual values in both the Nyquist plot and the Bode plot; this reveals that the fitting results are good. According to Table 1, the specimen produced from the sample according to Comparative Example 1 has a resistance attributable to a grain boundary. An impedance of the specimen according to Comparative Example 1 is three or more orders of magnitude smaller than an impedance of the specimen according to Example 1. This is presumably because the specimen according to Comparative Example 1 has a low degree of orientation and a low bulk resistance. According to Table 1, the bulk resistance of the specimen according to Comparative Example 1 is about four orders of magnitude smaller than the bulk resistance of the specimen according to Example 1. If the degree of orientation did not affect the performance of a capacitor, the bulk resistance of the specimen according to Comparative Example 1 would match the bulk resistance of the specimen according to Example 1. In other words, it is indicated that a high degree of orientation of a dielectric makes a great contribution to the performance of a capacitor.

(Comparative Example 2)

A sample according to Comparative Example 2 was produced in the same manner as in Example 1, and a specimen according to Comparative Example 2 for AC impedance measurement was produced in the same manner as in Example 1, except that the sample according to Comparative Example 2 was used and the value of the pressure L was changed to 530 MPa. For this specimen, it is thought that the application of the high pressure, namely 530 MPa, to the sample decreased the degree of orientation of the sample. The electrodes E1 and E2 each had a diameter of 2.5 mm. Moreover, the specimen according to Comparative Example 2 had a thickness of 0.98 mm.

(AC impedance measurement)

AC impedance measurement was performed for the specimen according to Comparative Example 2 for AC impedance measurement in the same manner as in Example 1.

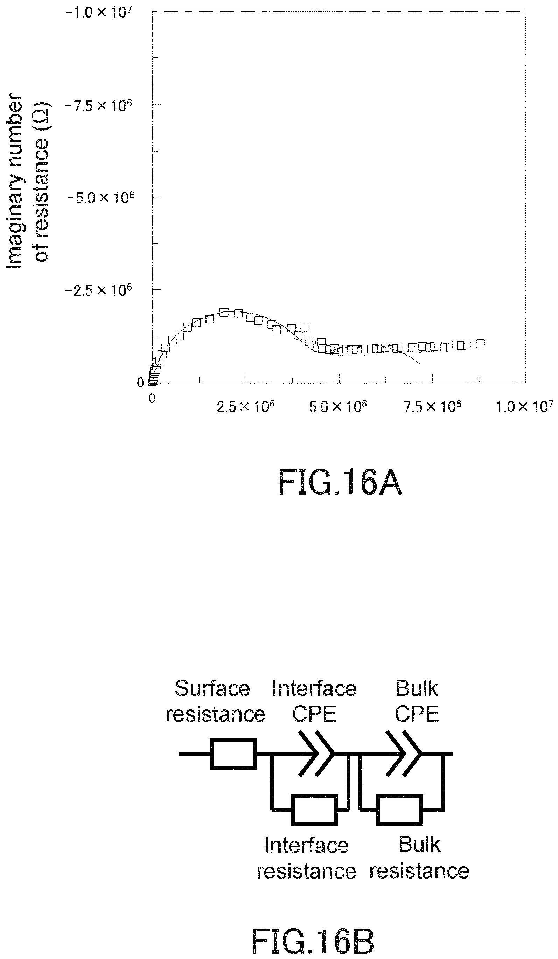

FIG. 16A and FIG. 16B respectively show a Nyquist plot obtained from the result of the AC impedance measurement for the specimen according to Comparative Example 2 and an equivalent circuit used for fitting. In FIG. 16A, the vertical axis represents the imaginary number of a resistance, while the horizontal axis represents the real number of the resistance. In FIG. 16A, a hollow symbol represents an actual value, while a solid line represents the fitting result. Table 1 shows values determined for components by the fitting using the equivalent circuit shown in FIG. 16B.

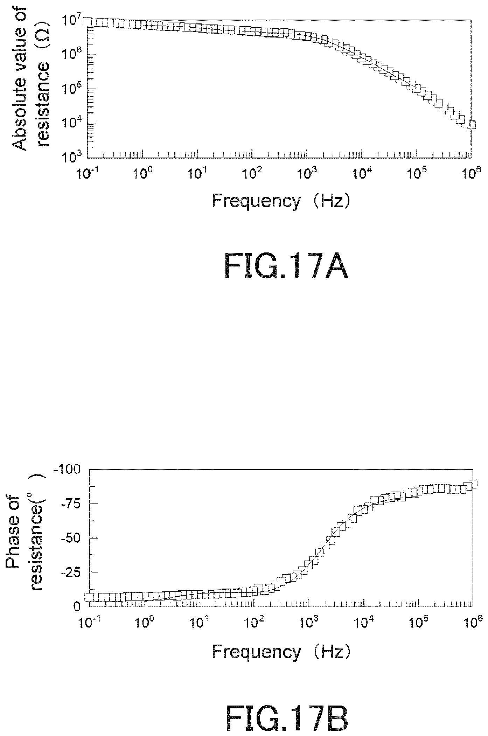

FIG. 17A is a Bode plot showing a relation between an absolute value of the resistance of the sample according to Comparative Example 2 and the frequency of the AC voltage. In FIG. 17A, the vertical axis represents the absolute value of the resistance, while the horizontal axis represents the frequency. FIG. 17B is a Bode plot showing a relation between a phase of the resistance of the specimen according to Comparative Example 2 and the frequency of the AC voltage. In FIG. 17B, the vertical axis represents the phase of the resistance, while the horizontal axis represents the frequency. In FIGS. 17A and 17B, a hollow symbol represents an actual value, while a solid line represents the fitting result.

The fitting results coincide with the actual values in both the Nyquist plot and the Bode plot; this reveals that the fitting results are good. In FIG. 16A, the Nyquist plot shows an arc-shaped locus, and the result is similar to what is reported in Non Patent Literature 1. Moreover, it is understood from Table 1 that the specimen produced from the sample according to Comparative Example 2 has a resistance attributable to a grain boundary. This is presumably because polycrystallization occurred due to the application of the high pressure, namely 530 MPa, to the sample.

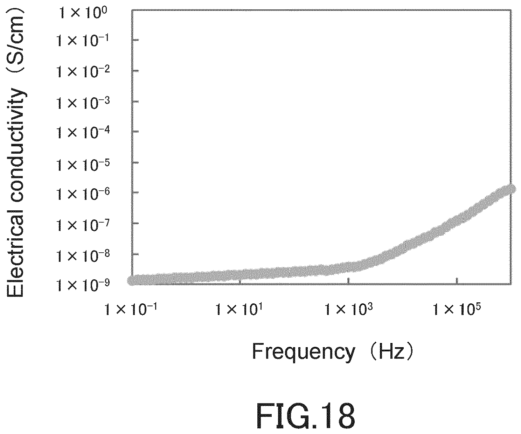

FIG. 18 is a graph showing a relation between an electrical conductivity of the specimen according to Comparative Example 2 in a thickness direction thereof and the frequency of the AC voltage. According to FIG. 18, the electrical conductivity in the thickness direction of the specimen according to Comparative Example 2 at $10^{-1}$ Hz is $1.4 \times 10^{-9}$ S/cm. FIG. 18 indicates that an electrical conductivity of the specimen according to Comparative Example 2 under DC voltage is slightly lower than $1.4 \times 10^{-9}$ S/cm. The specimen according to Comparative Example 2 has a higher electrical conductivity than the specimen according to Example 1, which indicates a higher likelihood of current leakage.

[Table 1]

|  | Example 1 | Comparative Example 1 | Comparative Example 2 |
|---|---|---|---|
| Surface resistance ($\Omega$) | $2.7 \times 10^3$ | $9.66 \times 10^{-6}$ | $6.53 \times 10^{-7}$ |
| Bulk CPE-T | $1.55 \times 10^{-10}$ | $2.30 \times 10^{-3}$ | $4.428 \times 10^{-11}$ |
| Bulk CPE-P | 0.995 | 0.06 | 0.926 |
| Bulk resistance (k$\Omega$) | $11.3 \times 10^3$ | 3.63 | $4.06 \times 10^3$ |
| Bulk capacity (F/m) | $1.56 \times 10^{-10}$ | $4.24 \times 10^{-40}$ | $2.23 \times 10^{-11}$ |
| Interface CPE-T | - | $3.80 \times 10^{-4}$ | $1.87 \times 10^{-8}$ |
| Interface CPE-P | - | 0.76806 | $6.41 \times 10^{-1}$ |
| Interface resistance (k$\Omega$) | - | 1.12 | $3.55 \times 10^3$ |
| Interface capacity (F/m) | - | $2.33 \times 10^{-4}$ | $4.07 \times 10^{-9}$ |

(Example 2)

An amount of 3.36 mL of water and 5.04 mL of ethanol were mixed to prepare a mixed solvent. The ethanol was purchased from FUJIFILM Wako Pure Chemical Corporation. A volume ratio between the water and the ethanol in the mixed solvent was 2:3. In this mixed solvent were dissolved 2.14 g of nickel chloride hexahydrate and 1.22 g of iron chloride hexahydrate to prepare a solution A. The nickel chloride hexahydrate and the iron chloride hexahydrate were purchased from FUJIFILM Wako Pure Chemical Corporation. The nickel chloride hexahydrate and the iron chloride hexahydrate were dissolved in the mixed solvent so that the total concentration of Ni ions and Fe ions would be 1.0 mol/liter and a ratio of the amount of substance of Fe ions to the total amount of substance of Ni ions and Fe ions would be 0.33. Furthermore, 460 μL of acetylacetone (ACAC) as a multidentate ligand was added to the solution A to obtain a multidentate-ligand-containing solution. The acetylacetone was purchased from Sigma-Aldrich Co., LLC. The amount of substance of the acetylacetone in the multidentate-ligand-containing solution was one third of the total amount of substance of Ni ions and Fe ions. The multidentate-ligand-containing solution was stirred for 30 minutes.

Next, a Ni plate was disposed in the above multidentate-ligand-containing solution. The Ni plate had an area of 2 cm$^2$ and a thickness of 0.1 cm. The pH of the multidentate-ligand-containing solution was 1. The Ni plate was purchased from The Nilaco Corporation. Propylene oxide (POX) as a pH increasing agent was added at 25°C to the multidentate-ligand-containing solution to obtain a mixed solution. The amount of the POX added was adjusted so that a ratio of the amount of substance of the POX to the amount of substance of chloride ions in the mixed solution would be 2. Specifically, the mixed solution was obtained by adding 4.58 mL of the POX to the multidentate-ligand-containing solution. The pH of the mixed solution was still 1. The mixed solution obtained was stirred for 1 minute. During the stirring, the POX gradually captured hydrogen ions in the solution, gradually increasing the pH of the solution. The resulting solution was allowed to stand still for about 3 days. The pH of the solution at the time was 9.5. After the resulting solution was allowed to stand still for about 3 days, a dielectric-including member according to Example 2 was collected.

Here, judging from the amounts of the nickel chloride hexahydrate and the iron chloride hexahydrate added to the mixed solvent, an amount of a generated LDH obtained by an ideal reaction of all Ni and Fe contained in the solution is expected to be 1520 mg. Additionally, since the volume of the Ni plate used is 0.4 cm$^3$ and the density of Ni is 8.91 g/cm$^3$, the mass of the Ni plate is 0.4 × 8.91 = 3.56 g. Hence, a ratio R1 was 3.56 g/1520 mg = 2.3. In the production of the dielectric-including member, the ratio R1 refers to a ratio of the mass of the added Ni plate to the mass of the generated LDH.

It should be noted that the above expected value of the amount of the generated LDH was derived in the following manner. The amount of substance of Ni ions and the amount of substance of Fe ions were respectively calculated from the amount of the nickel chloride hexahydrate and the amount of the iron chloride hexahydrate used for the preparation of the LDH. In addition, since the above compounds used for the preparation of the LDH were chlorides, the composition of the generated LDH was assumed to be $Ni_2Fe(OH)_6Cl \cdot nH_2O$ from a standpoint of electroneutrality. It is known from a prior literature that an amount n of water is approximately 1.5. Therefore, also in Example 2, n was assumed to be 1.5 in the composition of the generated LDH. A molecular weight of this LDH is 337.7 g/mol. Judging from the composition of the generated LDH, the amount of substance of the generated LDH is equal to the amount of substance of the iron chloride hexahydrate used. In Example 1, the amount of substance of the iron chloride hexahydrate used was 4.5 mmol. Hence, the amount of the generated LDH was calculated as 1520 mg.

(Example3)

A dielectric-including member according to Example 3 was obtained in the same manner as in Example 2, except that ACAC was not added to the solution A. The ratio R1 was 2.3 also in Example 3.

(Comparative Example 3)

An untreated Ni plate was used in Comparative Example 3. The Ni plate had an area of 2 cm$^2$ and a thickness of 0.1 cm. A surface of the Ni plate had a nickel oxide film.

[Evaluation 1: observation of surface of dielectric-including member]

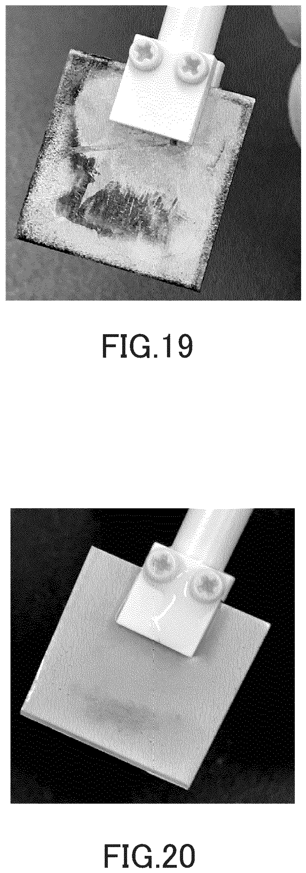

FIG. 19 is a photograph of the dielectric-including member according to Example 2. FIG. 20 is a photograph of the dielectric-including member according to Example 3. As shown in each of FIGS. 19 and 20, the LDH is thought to be on a portion having a darker color than the Ni plate .

For each of the dielectric-including members according to Examples 2 and 3, the portion having a darker color than the Ni plate and a portion showing the color of the Ni plate were subjected to element analysis. Specifically, surfaces of the dielectric-including members according to Examples 2 and 3 were observed using a scanning electron microscope (SEM), and elemental mapping was performed by energy dispersive X-ray analysis (EDX). A detection depth for the elemental mapping by EDX is, for example, several hundred $\mu$m. A detection target region is defined as (the area of a particular surface portion of the dielectric-including member observed using the SEM) $\times$ (the detection depth for the elemental mapping by EDX). A ratio of the amount of substance [mol] of atoms of Fe to the total amount of substance [mol] of all atoms in the detection target region was determined as a mole fraction of Fe. For the dielectric-including member according to Example 2, the mole fraction of Fe in the portion having a darker color than the Ni plate is 0.3%. On the other hand, for the dielectric-including member according to Example 2, the mole fraction of Fe in the portion showing the color of the Ni plate is less than a detection limit. Fe is an element included in the LDH. Therefore, the above results indicate that the LDH is present on the Ni plate in the dielectric-including member according to Example 2.

Likewise, for the dielectric-including member according to Example 3, the mole fraction of Fe in the portion having a darker color than the Ni plate is 0.3%. On the other hand, for the dielectric-including member according to Example 3, the mole fraction of Fe in the portion showing the color of the Ni plate is less than a detection limit. These results indicate that the LDH is present on the Ni plate in the dielectric-including member according to Example 3.

[Evaluation 2: capacity evaluation]

Capacities of the dielectric-including member according to Example 2, the dielectric-including member according to Example 3, and the untreated Ni plate according to Comparative Example 3 were evaluated. A potentiostat VersaSTAT 4 manufactured by Princeton Applied Research was used for the measurement. Impedance measurement was performed using a three-electrode system under the following conditions.

[Measurement conditions]

- Working electrode: the dielectric-including member according to Example 2, the dielectric-including member according to Example 3, or the untreated Ni plate according to Comparative Example 3
- Reference electrode: reversible hydrogen electrode
- Counter electrode: platinum wire
- Solution: 0.5 mol/liter of NaCl solution
- Measurement frequency: 1 Hz to 10000 Hz
- AC central electric potential: open-circuit potential
- AC voltage: 100 mV

A capacity C at a measurement frequency of 120 Hz was calculated by the following equation from a real part $Z_1$ and an imaginary part $Z_2$ of each impedance obtained by the above measurement and the measurement frequency $\omega$. Table 2 shows the results.

$$C = \{Z_2/(Z_1^2 + Z_2^2)\}/\omega$$

Table 2

| | Volume C at 120 Hz [F] |
|---|---|
| Example 2 | $1.5 \times 10^{-4}$ |
| Example 3 | $7.3 \times 10^{-5}$ |
| Comparative Example 3 | $4.0 \times 10^{-5}$ |

The capacities of the dielectric-including members according to Examples 2 and 3 are higher than the capacity of the untreated Ni plate according to Comparative Example 3. That is, the dielectric-including members according to Examples 2 and 3 have a high capacity. The dielectric-including members having a high capacity were able to be achieved owing to the LDHs included in the surfaces of the Ni plates.

(Example 4)

In Example 4, synthesis of a powder by hydrothermal synthesis and evaluation of anisotropy were performed. An amount of 1177.6 mg of nickel chloride hexahydrate, 1297.4 mg of iron chloride hexahydrate, and 277.6 mg of hexamethylenetetramine were dissolved in 80 ml of water to obtain a mixed solution. The nickel chloride hexahydrate and the iron chloride hexahydrate used were purchased from FUJIFILM Wako Pure Chemical Corporation. A fluorine resin container was charged with the mixed solution, and was sealed with a stainless steel pressure-resistant jig so as to prevent leakage during heating. The specimen in the fluorine resin container was held at 180°C for 10 hours to perform hydrothermal synthesis of an LDH. The synthesized specimen was taken out of the container after cooled. After washed with running water for 30 minutes to remove impurities, the specimen was dried naturally to obtain a dielectric-including member according to Example 4.

[Evaluation 3: measurement of electrical conductivity]

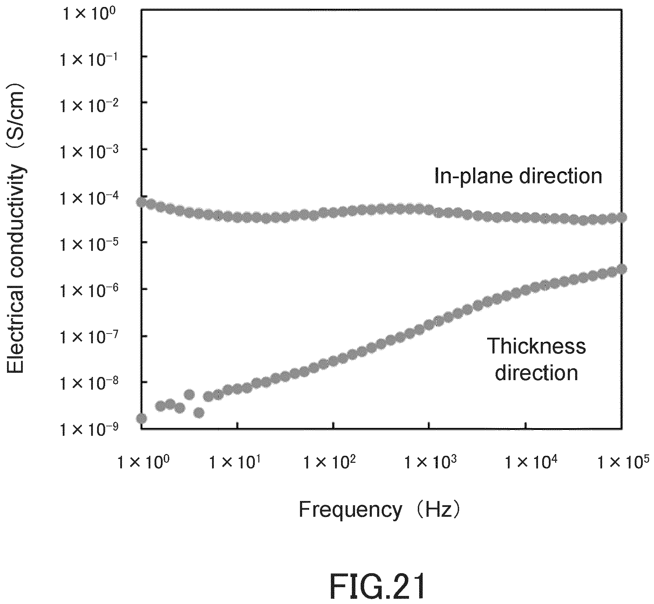

Impedance measurement was performed for the specimen according to Example 4 in a thickness direction thereof in the same manner as in Example 1, except that the LDH according to Example 4 was used. For the impedance measurement of the specimen according to Example 4 in an in-plane direction thereof, in the same manner as in Example 1, four separate terminals were formed using a silver paste (TK paste) manufactured by KAKEN TECH Co., Ltd., and an electrical conductivity of the specimen was measured by AC four-terminal sensing. FIG. 21 shows the results. FIG. 21 is a graph showing relations between the electrical conductivities of the specimen according to Example 4 in the thickness direction and the in-plane direction and the frequency of the AC voltage. In FIG. 21, the vertical axis represents the electrical conductivity, while the horizontal axis represents the frequency.

According to FIG. 21, the electrical conductivity of the specimen according to Example 4 in the in-plane direction at 1 Hz is $6.7 \times 10^{-5}$ S/cm. On the other hand, the electrical conductivity of the specimen according to Example 4 in the thickness direction at 1 Hz is $1.67 \times 10^{-9}$ S/cm. Therefore, for the specimen according to Example 4, a ratio of the electrical conductivity in the thickness direction to the electrical conductivity in the in-plane direction is 0.000025 at 1 Hz. As can be understood from FIG. 21, the electrical conductivity in the in-plane direction is almost constant. On the other hand, the electrical conductivity in the thickness direction keeps decreasing toward a low frequency side in the measurement range. Therefore, the ratio of the electrical conductivity in the thickness direction to the electrical conductivity in the in-plane direction should be smaller than 0.000025. Moreover, as can be understood from FIG. 21, the ratio of the electrical conductivity in the thickness direction under AC voltage to the electrical conductivity in the in-plane direction under AC voltage is 0.01 or less at 10 kHz or less. It is therefore concluded that current leakage is considerably reduced in the specimen according to Example 4.

INDUSTRIAL APPLICABILITY

The capacitor according to the present disclosure is useful in terms of reducing current leakage.

**Claims**

**1.** A capacitor comprising:

a first electrode;

a second electrode disposed to face a principal surface of the first electrode; and

a dielectric disposed between the first electrode and the second electrode, the dielectric being in contact with the first electrode and the second electrode, wherein

an electrical conductivity $\sigma_x$ of the dielectric in a particular direction perpendicular to the principal surface and an electrical conductivity $\sigma_y$ of the dielectric in a direction perpendicular to the particular direction satisfy a relation $\sigma_x/\sigma_y \leq 0.01$.

2.  The capacitor according to claim 1, wherein the dielectric is oriented in the particular direction.

3.  The capacitor according to claim 1 or 2, wherein the dielectric has a layered structure extending along the direction perpendicular to the particular direction.

4.  The capacitor according to claim 3, wherein the layered structure includes a first layer including a diamine and a second layer including tin(IV) sulfide, the second layer disposed alternately with the first layer.

5.  The capacitor according to claim 4, wherein the tin(IV) sulfide is a single crystal.

6.  The capacitor according to claim 4 or 5, wherein the diamine is ethylenediamine.

7.  The capacitor according to claim 3, wherein the layered structure is formed of a layered double hydroxide.

8.  The capacitor according to claim 7, wherein the layered double hydroxide includes a multidentate ligand.

9.  The capacitor according to claim 8, wherein the multidentate ligand includes at least one selected from the group consisting of acetylacetone and a citrate.

10. The capacitor according to any one of claims 7 to 9, wherein the layered double hydroxide includes a transition metal.

11. The capacitor according to claim 10, wherein the transition metal includes at least one selected from the group consisting of V, Cr, Mn, Fe, Co, Ni, Cu, W, and Ru.

12. The capacitor according to claim 10 or 11, wherein the transition metal includes at least one selected from the group consisting of Ni and Fe.

13. The capacitor according to any one of claims 7 to 12, wherein

    at least one selected from the group consisting of the first electrode and the second electrode includes a metal material, and

    the metal material includes at least one selected from the group consisting of V, Cr, Mn, Fe, Co, Ni, and Cu.

14. The capacitor according to claim 13, wherein the metal material includes Ni.

15. The capacitor according to any one of claims 1 to 14, wherein at least one selected from the group consisting of the first electrode and the second electrode is a metal plate.

16. The capacitor according to any one of claims 1 to 15, wherein the electrical conductivity $\sigma_x$ is $1 \times 10^{-10}$ S/cm or less.

17. An electrical circuit comprising the capacitor according to any one of claims 1 to 16.

18. A circuit board comprising the capacitor according to any one of claims 1 to 16.

19. An apparatus comprising the capacitor according to any one of claims 1 to 16.

<u>1a</u>

12

20

25

11

x

y

FIG.1

FIG.2

40

50
41

# FIG.3

30

31

32

31

⊘ : M1$^{2+}$  ● : M2$^{3+}$  ○ : OH$^{-}$

▥ : A$^{n-}$  ◐ : H$_2$O

# FIG.4

FIG.5

FIG.6

FIG.7

FIG.8A

FIG.8B

FIG.8C

FIG.9

FIG.10

FIG.11A

FIG.11B

FIG.12A

FIG.12B

FIG.13

FIG.14A

FIG.14B

FIG.15A

FIG.15B

FIG.16A

FIG.16B

FIG.17A

FIG.17B

FIG.18

FIG.19

FIG.20

FIG.21

FIG.22A

FIG.22B

$CPE_{gb}$

$CPE_b$

$R_{gb}$

$R_b$

FIG.23

## INTERNATIONAL SEARCH REPORT

| | International application No. |
|---|---|
| | **PCT/JP2022/018645** |

### A. CLASSIFICATION OF SUBJECT MATTER

*H01G 4/06*(2006.01)i; *H01G 9/00*(2006.01)i; *H01G 9/07*(2006.01)i
FI:    H01G4/06; H01G9/00 290A; H01G9/07

According to International Patent Classification (IPC) or to both national classification and IPC

### B. FIELDS SEARCHED

Minimum documentation searched (classification system followed by classification symbols)

H01G4/06; H01G9/00; H01G9/07

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | WO 2018/180029 A1 (PANASONIC INTELLECTUAL PROPERTY MANAGEMENT CO., LTD.) 04 October 2018 (2018-10-04)<br>entire text, all drawings | 1-19 |
| A | JP 2016-008323 A (KOJIMA PRESS INDUSTRIES CO., LTD.) 18 January 2016 (2016-01-18)<br>entire text, all drawings | 1-19 |
| A | JP 2003-007983 A (NATIONAL INSTITUTE FOR MATERIALS SCIENCE) 10 January 2003 (2003-01-10)<br>entire text, all drawings | 1-19 |
| A | WO 2004/085339 A1 (JAPAN SCIENCE AND TECHNOLOGY AGENCY) 07 October 2004 (2004-10-07)<br>entire text, all drawings | 1-19 |

☐ Further documents are listed in the continuation of Box C.    ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **15 July 2022** | **26 July 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
**Information on patent family members**

| International application No. |
| --- |
| **PCT/JP2022/018645** |

| Patent document cited in search report | | | Publication date (day/month/year) | Patent family member(s) | | | Publication date (day/month/year) |
| --- | --- | --- | --- | --- | --- | --- | --- |
| WO | 2018/180029 | A1 | 04 October 2018 | US | 2020/0006011 | A1 | |
| | | | | entire text, all drawings | | | |
| JP | 2016-008323 | A | 18 January 2016 | (Family: none) | | | |
| JP | 2003-007983 | A | 10 January 2003 | (Family: none) | | | |
| WO | 2004/085339 | A1 | 07 October 2004 | US | 2007/0040206 | A1 | |
| | | | | entire text, all drawings | | | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **MORALES, JULIAN et al.** Synthesis and characterization of diamine intercalation compounds of SnS2 single crystals. *Journal of Solid State Chemistry,* 2000, vol. 150 (2), 391-398
- **TOH, M. L et al.** Intercalation of organic molecules into SnS2 single crystals. *Journal of Solid State Chemistry,* 2013, vol. 198, 224-230
- **NASU et al.** Gas emission from quartz glass. *Journal of the Illuminating Engineering Institute of Japan,* vol. 74 (9), 595-600
- **F. IZUMI ; K. MOMMA.** *Solid State Phenom,* 2007, vol. 130, 15-20